# EUROPÄISCHE PATENTSCHRIFT

(11) **EP 3 966 157 B1**
(45) Veröffentlichungstag und Bekanntmachung des Hinweises auf die Patenterteilung: **20.03.2024**
(21) Anmeldenummer: 20724410.4
(22) Anmeldetag: 23.04.2020
(51) Int. Cl.: B23K 26/36

(54) **VERFAHREN ZUR HERSTELLUNG VON MIKROSTRUKTUREN IN EINEM GLASSUBSTRAT**
METHOD FOR PRODUCING MICROSTRUCTURES IN A GLASS SUBSTRATE
PROCÉDÉ DE PRODUCTION DE MICROSTRUCTURES DANS UN SUBSTRAT DE VERRE

(30) Priorität: 06.05.2019 DE 102019111634
(43) Veröffentlichungstag der Anmeldung: 16.03.2022
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE)
(74) Vertreter: Scheffler, Jörg
(86) Internationale Anmeldenummer: PCT/DE2020/100333
(87) Internationale Veröffentlichungsnummer: WO 2020/224706

(56) Entgegenhaltungen:
- WO-A1-2018/162385
- DE-A1-102013 103 370
- US-A1- 2017 094 768

## Beschreibung

Die Erfindung betrifft ein Verfahren zur Herstellung von Mikrostrukturen in einem Glassubstrat, die durch einander gegenüberliegende Außenflächen eingebracht werden, wobei zunächst Modifikationen mittels einer Laserstrahlung in zumindest eine Außenfläche eingebracht werden und es aufgrund der Lasereinwirkung bei der Modifikation zu einer chemischen Umwandlung des Substratmaterials kommt und anschließend durch ein Ätzverfahren die Mikrostrukturen mittels eines anisotropen Materialabtrags durch eine Vielzahl insbesondere zumindest abschnittsweise kegelförmiger Ausnehmungen in der zumindest einen Außenfläche des Glassubstrats erzeugt werden.

Bei diesem Verfahren wird ein Laserstrahl der Laserstrahlung derart kurzzeitig auf das Glassubstrat gerichtet, dass lediglich eine Modifikation des Glassubstrats entlang einer Strahlachse des Laserstrahls erfolgt, ohne dass es zu einer das Glassubstrat durchdringenden Zerstörung kommt. Im nächsten Schritt kommt es zu einem anisotropen Materialabtrag beschränkt auf diejenigen Bereiche des Glassubstrats, die zuvor eine Modifikation mittels des Laserstrahls erfahren haben. So entsteht eine Ausnehmung oder Durchbrechung in dem Glassubstrat.

Dabei kommt es aufgrund der Lasereinwirkung bei der Modifikation zu einer chemischen Umwandlung des Substratmaterials, welche nur geringe Auswirkungen auf die physikalischen Eigenschaften bzw. die äußerliche Beschaffenheit des Substrats hat. Insbesondere entsteht also durch die Lasereinwirkung kein oder ein lediglich äußerst geringer Materialabtrag auf der Oberfläche des Substrats. Der Laserenergieeintrag kann dadurch auf wenige Pulse oder einen Einzelpuls beschränkt werden, da diese lediglich zur Anregung bzw. Auslösung einer Reaktion und einer Modifikation durch Umwandlung dient, deren Wirkung erst im nachfolgenden Verfahrensschritt zu dem gewünschten Materialabtrag genutzt wird.

Das gattungsgemäße Verfahren zur Präzisionsbearbeitung von Glas mittels laserinduzierten Tiefenätzens ist unter der Bezeichnung LIDE (Laser Induced Deep Etching) bekannt geworden. Dabei ermöglicht das LIDE-Verfahren das Einbringen von präzisen Ausnehmungen und Strukturen in höchster Geschwindigkeit und schafft somit die Voraussetzungen für den vermehrten Einsatz von Glas als Werkstoff in der Mikrosystemtechnik. Die LIDE-Technologie ermöglicht es erstmals, mit einzelnen Laserpulsen Modifikationen über die gesamte Glasdicke zu realisieren. Dies ist die Basis für die Erzeugung von tiefen Strukturen wie Durchgangslöchern oder Mikroschnitten.

Die DE 10 2013 103 370 A1 betrifft ein solches Verfahren zum Einbringen einer Mehrzahl von Durchbrechungen in ein als Interposer einsetzbares Glassubstrat mittels eines Laserstrahls.

Aus der DE 10 2014 113 339 A1 ist ein Verfahren zur Erzeugung von Ausnehmungen mittels eines Laserstrahls innerhalb von transparenten oder transmissiven Materialien bekannt. Für jede Ausnehmung wird ein Filament durch abwechselnde Selbstfokussierung und Defokussierung von Laserpulsen im transparenten Material erzeugt, wodurch lineare Ketten von Modifikationen oder kanälemodifizierten Materials mit einem im Wesentlichen konstanten Durchmesser entstehen. Indem das Material zumindest in seinen modifizierten Bereichen einem anisotropen Materialabtrag, beispielsweise einem Ätzverfahren unterzogen wird, entstehen anstelle der Filamente Ausnehmungen oder Durchbrechungen in dem Material.

Es ist auch bereits bekannt, auf diese Weise überbrückende Strukturen zu schaffen, die als Membran die Basis für mikromechanische Systeme, beispielsweise Druckerfassungsvorrichtungen oder Mikrofone, bilden.

Außerdem lässt sich auch durch das reaktive lonentiefenätzen (deep reactive ion etching, DRIE) ein kontrollierter Abtrag zur Reduzierung der Schichtstärke bis auf die gewünschte Reststärke erreichen.

Die DE 10 2017 216 418 A1 betrifft eine Druckerfassungsvorrichtung mit verlängerter, flacher, polygonförmiger Kavität, insbesondere eine auf einem mikromechanischen System (MEMS) basierende Druckerfassungsvorrichtung.

Weiterhin wird in der EP 2 503 859 A1 ein Substrat beschrieben, das eine Durchgangsöffnung aufweist, welche die erste und zweite Hauptfläche des Substrats verbindet und die mit einem Leiter gefüllt ist. In einem vertikalen Querschnitt des Substrats hat das Durchgangsloch eine trapezförmige Form.

Die US 2017 / 0 094 768 A1 bezieht sich auf ein Verfahren zur Herstellung von Mikrostrukturen in einem Siliziumsubstrat das eine Metallschicht umfasst und eine hohle Innenfläche definiert. Hierzu wird die Vorderseite des Siliziumwafers abgetragen, bis sich die Siliziumkristallebenen schneiden, um einen pyramidenförmigen Hohlraum zu bilden und der Hohlraum wird mit einer Schicht überdeckt, um durch Ätzen von der Rückseite des Siliziumwafers bis zur abgeschiedenen Schicht eine Membran herzustellen.

Die WO 2018 / 162 385 A1 betrifft ein Verfahren zum Einbringen zumindest einer Ausnehmung, insbesondere Durchbrechung, in ein transparentes oder transmissives, Material, wobei das Material mittels eines Lasers entlang einer Strahlachse selektiv modifiziert und Modifikationen mit unterschiedlichen Charakteristika erzeugt werden. Der Ätzprozess verläuft in dem Material dadurch inhomogen derart, dass die Ätzraten in den modifizierten Bereichen bei im Übrigen unveränderten Ätzbedingungen in den mit unterschiedlichen Charakteristika modifizierten Bereichen voneinander abweichen.

Die Aufgabe der vorliegenden Erfindung besteht darin, ein weiter verbessertes Herstellungsverfahren für solche, insbesondere auch komplexe Mikrostrukturen zu schaffen. Diese Aufgabe wird mit einem Verfahren zur Herstellung von Mikrostrukturen gemäß Anspruch 1 gelöst. Bevorzugte Ausgestaltungen des Verfahrens sind in den Unteransprüchen angegeben.

Erfindungsgemäß wird eine gegenüber der Ätzwirkung des Ätzverfahrens resistente Schicht in einem zumindest einzelne Ausnehmungen einschließenden Bereich auf lediglich eine der beiden Außenflächen als erste Außenfläche in Form einer konturierten, nicht-ebenen Deckschicht aufgebracht und danach das Ätzverfahren fortgesetzt bzw. ein weiteres Ätzverfahren des Glassubstrats durchgeführt, sodass es zu einem Materialabtrag in Form von weiteren Ausnehmungen in der der Deckschicht abgewandten zweiten Außenfläche kommt, bis die Ausnehmungen der zweiten Außenfläche die Deckschicht erreicht haben und die Deckschicht in der jeweiligen Ausnehmung frei liegt und durch die zweite Ausnehmung zugänglich ist. Erfindungsgemäß wird so erstmals die Möglichkeit zur Herstellung einer die Ausnehmungen überbrückenden dreidimensionalen Deckschicht geschaffen. Hierzu werden zunächst in zumindest einer der beiden Außenflächen, vorzugsweise in beide Außenflächen einander gegenüberliegende Ausnehmungen in den beiden Außenflächen des Glassubstrats durch eine an sich bekannte Modifikation und ein anschließendes anisotropes Ätzen eingebracht. Die so geschaffene Struktur mit regelmäßig, beispielsweise entsprechend einem vorbestimmten Muster, oder unregelmäßig eingebrachten Ausnehmungen, deren Form, Orientierung und Größe durch die Art der eingebrachten Modifikationen bestimmt und für unterschiedliche Ausnehmungen abweichend eingestellt werden kann, bildet die Basis für die aufzubringende Deckschicht. Diese erfüllt dabei einerseits die Funktion eines Ätzresists zum Schutz vor einem weiteren Ätzabtrag bei einer nachfolgenden Ätzbehandlung, andererseits jedoch auch Anforderungen an das aus dem Glassubstrat herzustellende Erzeugnis. Bei einer einfachen Ausprägung des Materialabtrags entstehen regelmäßige kegelförmige Ausnehmungen. Diese Kontur nimmt auch die darauf aufgebrachte Deckschicht an. Die gewünschte Überhangstruktur entsteht anschließend dadurch, dass der anisotrope Materialabtrag ausgehend von der zweiten Außenfläche, die der Deckschicht abgewandt ist, fortgesetzt wird, bis diese schließlich bis zu der Deckschicht reichen und diese somit auch von der zweiten Außenfläche zugänglich ist. Das Ätzen wird dann beendet, wenn die durch die Ausnehmung in der zweiten Außenfläche freigelegte Unterseite der Deckschicht die gewünschte Größe hat, indem die Ausnehmung verbreitert wird. Somit ergibt sich erstmals ein Glassubstrat mit Überhangstrukturen, die einerseits eine nahezu beliebige Kontur oder Topographie aufweisen und andererseits zugleich als Trenn- bzw. Begrenzungsfläche der Ausnehmung dienen, wobei die Deckschicht an den jeweiligen Einsatzzweck angepasste Eigenschaften aufweisen kann.

Gemäß einer bevorzugten Variante des Verfahrens wird die zweite Außenfläche durch das Ätzen derart abgetragen, dass die Deckschicht der ersten Außenfläche gegenüber der verbliebenen Ebene der zweiten Außenfläche hervortritt. Indem also der Ätzvorgang bei Erreichen der Deckschicht der ersten Außenfläche nicht beendet, sondern fortgesetzt wird, kommt es zu einem flächigen Materialabtrag an der zweiten Außenfläche, in dessen Folge die Materialstärke des Glassubstrats reduziert wird. Es ist leicht verständlich, dass der Ätzvorgang so eingestellt werden kann, dass die verbleibende Materialstärke geringer ist als die Erstreckung der Deckschicht in die Ausnehmung hinein, sodass die Spitze der Deckschicht dadurch in derselben Ebene wie die zweite Außenfläche liegt oder gegenüber dieser hervortritt. Es ergibt sich somit ein Muster von beabstandeten Vorsprüngen der Deckschicht in dem Glassubstrat, die dadurch in optimaler Weise zur Kontaktierung insbesondere auch komplexer elektrischer Mikrostrukturen genutzt werden kann.

Obwohl auch eine Variante denkbar ist, in welcher das Glassubstrat durch die Ätzwirkung vollkommen aufgelöst wird, sodass nur die Deckschicht erhalten bleibt, hat es sich dennoch als sinnvoll erwiesen, wenn die in die Ausnehmungen hineinreichenden Vorsprünge der Deckschicht durch Bereiche des Glassubstrats getrennt, insbesondere auch elektrisch isoliert sind.

Vorzugsweise kann die Deckschicht beispielsweise gute elektrisch leitende Eigenschaften aufweisen, sodass die Ausnehmungen in der zweiten Außenfläche beispielsweise als Probenbehälter verwendet werden können, deren Bodenfläche durch die Deckschicht als elektrische Kontaktierung gebildet ist. Dadurch eignet sich das Glassubstrat auch als Sensor zur Bestimmung bestimmter Eigenschaften einer Substanz in der Ausnehmung.

Eine andere, ebenfalls besonders vielversprechende Ausgestaltungsform des erfindungsgemäßen Verfahrens wird dadurch erreicht, dass die zweite Außenfläche ebenfalls mit einer Deckschicht versehen wird, wobei besonders bevorzugt die Deckschicht auf die zweite Außenfläche aufgebracht wird, nachdem durch den fortschreitenden Materialabtrag die Ausnehmungen in der zweiten Außenfläche die Deckschicht der ersten Außenfläche erreicht haben. Indem die zweite Deckschicht auf die zweite Außenfläche unter Aussparung der bereits zuvor eingebrachten Ausnehmungen aufgebracht wird, beschränkt sich der weitere Materialabtrag auf die Innenwandflächen der Ausnehmungen, während die Bereiche der zweiten Außenfläche zwischen den Ausnehmungen durch die zweite Deckschicht vor einem weiteren Materialabtrag optimal geschützt sind. Auf diese Weise lassen sich Ausprägung und Form der Ausnehmungen, insbesondere das Aspektverhältnis der Ausnehmungen, in der gewünschten Weise einstellen.

In besonders vorteilhafter Weise wird der Kegelwinkel der Ausnehmungen durch die Deckschicht der zweiten Ausnehmung und/oder die Laserparameter eingestellt, wobei die Deckschicht der zweiten Außenfläche nach einer Unterbrechung des Ätzprozesses aufgebracht werden kann und durch die verbleibende Restdauer des Ätzprozesses im Verhältnis zu der vorangegangenen Ätzdauer der Kegelwinkel, insbesondere auch in Achsrichtung der Modifikation, unterschiedlich eingestellt werden kann. Der Kegelwinkel kann durch mehrfache Modifikationen in einem sehr geringen Abstand zu einer vorangegangenen Modifikation eingestellt werden.

Es ist offensichtlich, dass die Deckschicht nicht auf die gesamte erste und/oder zweite Außenfläche aufgebracht werden muss, sondern sich auch auf Teilbereiche beschränken kann. Weiterhin können auch die Materialeigenschaften der Deckschicht in unterschiedlichen Bereichen der Außenfläche variieren oder eine unterschiedliche Schichtdicke aufweisen.

Eine weitere besonders praxisnahe Abwandlung des erfindungsgemäßen Verfahrens wird dadurch erreicht, dass die Modifikationen in beide Außenflächen mittels mehrerer, die beiden Außenflächen jeweils verbindenden Laserstrahlen von einer Seite eingebracht werden. Indem also die Ausnehmungen durch Modifikationen entlang der die beiden Außenflächen verbindenden Strahlachse der Laserstrahlung eingebracht werden, sind die daraus bei dem nachfolgenden Ätzprozess entstehenden Ausnehmungen koaxial. Eine kegelförmige oder konische Deckschicht der Ausnehmung der ersten Außenfläche ist somit in der gegenüberliegenden Ausnehmung der zweiten Außenfläche zentriert.

Obwohl die Strahlachse der Modifikationen und der dementsprechend nachfolgend erzeugten Ausnehmungen mit ihrer Mittelachse vorzugsweise senkrecht zu der jeweiligen Oberfläche eingebracht werden, können hiervon abweichend auch unterschiedliche Winkellagen eingestellt werden, sodass die Achsen der Ausnehmungen gegenüber der Deckschicht geneigt angeordnet sind.

Dabei erfolgt der Energieeintrag mittels einer Laserstrahlung in das Glassubstrat derart, dass der Fokus der Laserstrahlung eine räumliche Strahlformung entlang einer Strahlachse der Laserstrahlung erfährt. Dadurch entstehen entlang der Strahlachse räumlich gestreckte Modifikationen in dem Glassubstrat, die bei der anschließenden Einwirkung eines ätzenden Mediums und durch sukzessives Aufätzen infolge eines anisotropen Materialabtrags in dem jeweiligen Bereich der Modifikationen in dem Glassubstrat die gewünschten Mikrostrukturen erzeugen. Um das Glassubstrat nicht einem schlagartigen Energieeintrag auszusetzen, durch den sonstige Eigenschaften des Glassubstrats in unerwünschter Weise verändert werden könnten, können die Modifikationen auch durch Gruppen von Einzelpulsen erzeugt werden, deren zeitlicher Abstand innerhalb derselben Gruppen beispielsweise kleiner ist als 1 µs, wobei der zeitliche Abstand zwischen zwei aufeinanderfolgenden Gruppen ein Vielfaches des zeitlichen Abstands zwischen den Einzelpulsen beträgt. Dabei entstehen die gewünschten Modifikationen durch Akkumulieren der Intensitäten der Einzelpulse einer jeweiligen Gruppe, wobei der Fokus der Laserstrahlung während der Dauer jeder Gruppe gegenüber dem Glassubstrat unverändert ist.

Die auf die erste und/oder zweite Außenfläche aufgebrachte Deckschicht kann neben der Schutzwirkung gegenüber dem Ätzangriff auch die für das herzustellende Erzeugnis wesentlichen Eigenschaften aufweisen. Gemäß einer bevorzugten Ausgestaltung kann zumindest eine Deckschicht mit einer zusätzlichen funktionellen Schicht verstärkt werden, die beispielsweise besondere elektrische Eigenschaften aufweisen kann.

Die mittels des erfindungsgemäßen Verfahrens herstellbaren Erzeugnisse sind überaus vielfältig und können nicht umfassend aufgezählt werden. Neben Sensoren und Kontaktierungselementen eignet sich das Verfahren beispielsweise auch für Elektronenemitter, wenn zwischen den gegenüberliegenden Deckschichten eine elektrische Spannung angelegt wird.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipdarstellung in einem Querschnitt in
- Fig. 1: ein Glassubstrat nach einer zwischen gegenüberliegenden Außenflächen durchgehenden Lasermodifikation;
- Fig. 2: das Glassubstrat mit kegelförmigen Ausnehmungen nach einem beidseitigen Ätzprozess;
- Fig. 3: das Glassubstrat mit einer Beschichtung auf einer ersten Außenfläche;
- Fig. 4: das Glassubstrat mit einseitig vergrößerter Ausnehmung nach einem weiteren Ätzprozess;
- Fig. 5: das Glassubstrat mit reduzierter Materialstärke in Folge eines fortgesetzten Ätzprozesses;
- Fig. 6: das Glassubstrat mit einer weiteren, auf die zweite Außenfläche aufgebrachten Beschichtung.

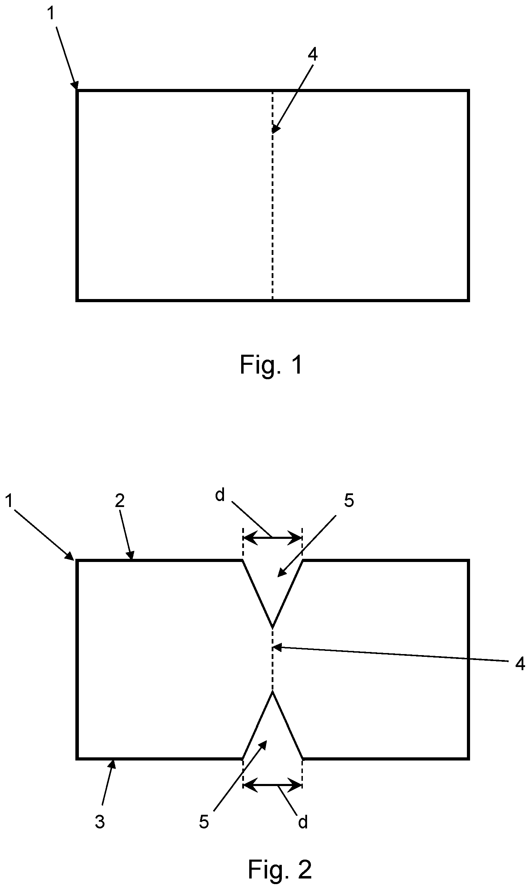

Das erfindungsgemäße Verfahren zur Herstellung von Mikrostrukturen in einem Glassubstrat 1 wird nachstehend anhand der Figuren 1 bis 6 näher erläutert, wobei zum besseren Verständnis lediglich ein kleiner Ausschnitt des Glassubstrats 1 dargestellt ist. Hierbei wird zunächst eine zwischen einander gegenüberliegenden Außenflächen 2, 3 durchgehende Lasermodifikation 4 in das Glassubstrat 1 eingebracht.

Dadurch entstehen infolge eines durch ein nachfolgendes Ätzverfahren bewirkten anisotropen Materialabtrags eine Vielzahl in der Figur 2 dargestellten kegelförmigen Ausnehmungen 5 in dem Glassubstrat 1.

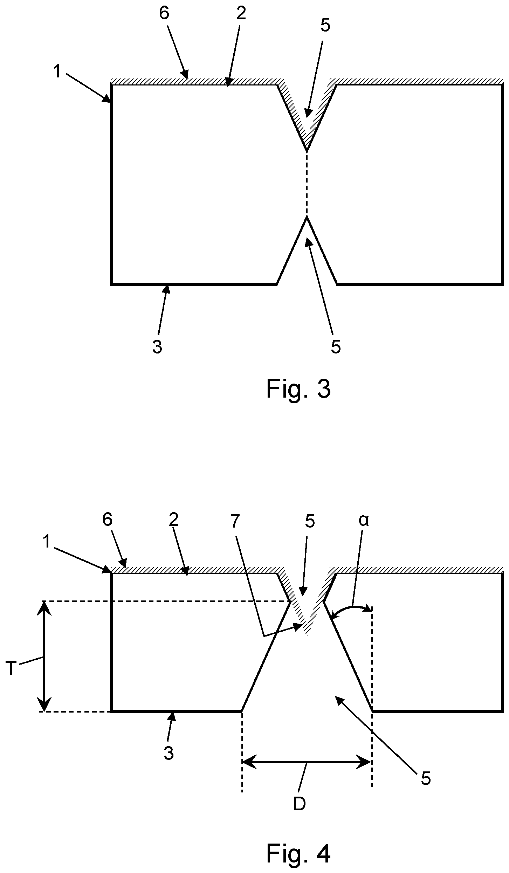

Sobald die Ausnehmungen 5 mit der gewünschten Größe d entstanden sind, wird der Ätzprozess unterbrochen und auf die obere, erste Außenfläche 2 eine gegenüber dem Ätzangriff resistente, hier als Metallschicht ausgeführte Deckschicht 6 aufgebracht. Wie zu erkennen folgt die Deckschicht 6 der zuvor eingebrachten Kontur der Außenfläche 2 und bildet somit im Bereich der Ausnehmungen 5 konkave, kegelförmige Vertiefungen zwischen einem im Übrigen ebenen Verlauf der ersten Außenfläche 2, wie dies in Figur 3 erkennbar ist.

Im Anschluss wird das so beschichtete Glassubstrat 1 weiter geätzt, wobei es zu einem weiteren Materialabtrag in der Ausnehmung 5 und einer zunehmenden Größe D dieser Ausnehmung 5 an der der Deckschicht 6 abgewandten zweiten Außenfläche 3 kommt, während die von der Deckschicht 6 als Ätzresist geschützte erste Außenfläche 2 unverändert erhalten bleibt. Durch den fortschreitenden Materialabtrag kommt es zu einer Vertiefung T der Ausnehmung 5, bis diese schließlich eine Rückseite 7 der Deckschicht 6 erreicht hat und der Ätzprozess beendet wird, wie dies in Figur 4 dargestellt ist. Dadurch erhält die die Ausnehmungen 5 überbrückende Deckschicht 6 erfindungsgemäß eine dreidimensional konturierte Beschaffenheit, die einer insbesondere regelmäßigen Mikrostruktur folgt. Indem also die Deckschicht 6 in die Ausnehmungen 5 der zweiten Außenfläche 3 hineinragt, kann die so geschaffene Struktur beispielsweise als Sensor verwendet werden, wobei die Ausnehmung 5 eine Probe einer Substanz aufnimmt.

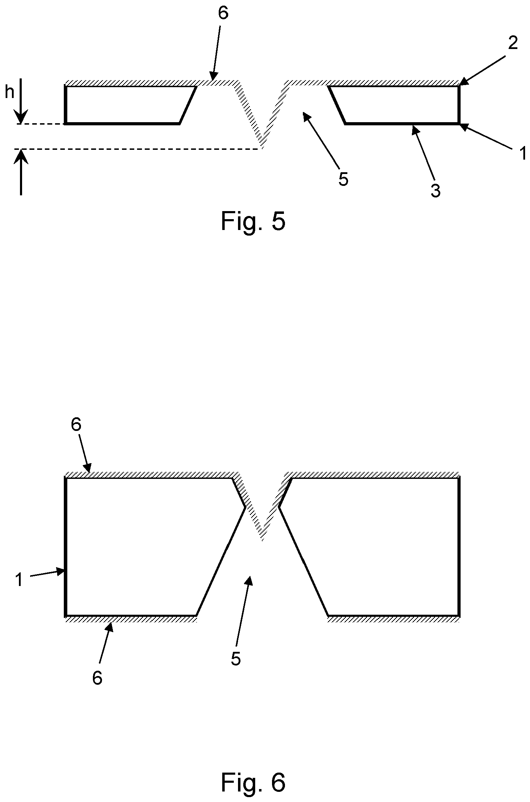

Der Ätzprozess kann allerdings auch weiter fortgesetzt werden, wie dies in Figur 5 verdeutlicht ist. Dabei wird durch den fortgesetzten Materialabtrag eine wesentliche Reduzierung der Materialstärke des Glassubstrats 1 erreicht, bis die konturierte Deckschicht 6 schließlich mit einer Höhe h gegenüber der Ebene der zweiten Außenfläche 3 hervortritt. Die kegelförmigen Bereiche der Deckschicht 6 bilden mit ihren Kegelspitzen vorspringende Kontaktpunkte beispielsweise für Schaltungsträger, wodurch sich eine erhebliche Vereinfachung der Kontaktierung solcher Schaltungsträger erreichen lässt.

Weiterhin kann bei einer in Figur 6 gezeigten Variante auch die zweite Außenfläche 3 mit einer Metallschicht als Deckschicht 6 versehen werden. Diese kann entweder als ein Zwischenschritt während des Ätzprozesses aufgebracht werden, um so den Fortschritt des Materialabtrags, beispielsweise den Kegelwinkel α zu steuern, oder aber nach Abschluss des Ätzverfahrens zur Herstellung eines gewünschten Erzeugnisses, wie beispielsweise einer Elektronenkanone.

### BEZUGSZEICHENLISTE

- 1: Glassubstrat
- 2: Außenfläche
- 3: Außenfläche
- 4: Lasermodifikation
- 5: Ausnehmung

- 6: Deckschicht
- 7: Rückseite

- T: Vertiefung
- d, D: Größe
- h: Höhe
- α: Kegelwinkel

## Patentansprüche

1. Verfahren zur Herstellung von Mikrostrukturen in einem Glassubstrat (1), wobei zunächst Modifikationen mittels einer Laserstrahlung in zumindest ein Volumen zwischen einander gegenüberliegenden Außenflächen (2, 3) eingebracht werden, wobei es aufgrund der Lasereinwirkung bei der Modifikation zu einer chemischen Umwandlung des Substratmaterials kommt, und anschließend durch ein Ätzverfahren mittels eines anisotropen Materialabtrags eine Vielzahl insbesondere zumindest abschnittsweise kegelförmiger Ausnehmungen (5) in der zumindest einen Außenfläche (2, 3) des Glassubstrats (1) erzeugt werden, wobei nach dem Ätzen eine gegenüber der Ätzwirkung des Ätzverfahrens resistente Schicht als Deckschicht (6) in einem zumindest einzelne Ausnehmungen (5) einschließenden Bereich auf lediglich eine der beiden Außenflächen (2) als erste Außenfläche aufgebracht wird, und danach ein weiteres Ätzverfahren des Glassubstrats (1) durchgeführt wird, sodass es zu einem Materialabtrag in der der Deckschicht (6) abgewandten zweiten Außenfläche (3) kommt, bis die so erzeugten und/oder vergrößerten Ausnehmungen (5) der zweiten Außenfläche (3) die Deckschicht (6) erreicht haben.

2. Verfahren nach Anspruch 1, wobei die zweite Außenfläche (3) durch das Ätzen derart abgetragen wird, dass die Deckschicht (6) der ersten Außenfläche (2) gegenüber der verbliebenen Ebene der zweiten Außenfläche (3) hervortritt.

3. Verfahren nach Anspruch 1 oder 2, wobei die Deckschicht (6) aus einer Materialzusammensetzung mit einer guten elektrischen Leitfähigkeit aufgebracht wird.

4. Verfahren nach zumindest einem der vorhergehenden Ansprüche, wobei auf die zweite Außenfläche (3) eine Deckschicht (6) aufgebracht wird.

5. Verfahren nach zumindest einem der vorhergehenden Ansprüche, wobei die Deckschicht (6) auf die zweite Außenfläche (3) aufgebracht wird, nachdem durch den fortschreitenden Materialabtrag die Ausnehmungen (2) in der zweiten Außenfläche (3) die Deckschicht (6) der ersten Außenfläche (2) erreicht haben.

6. Verfahren nach zumindest einem der vorhergehenden Ansprüche, wobei der Kegelwinkel (α) der Ausnehmungen (5) durch die Deckschicht (6) der ersten Außenfläche (2) und/oder die Laserparameter eingestellt wird.

7. Verfahren nach zumindest einem der vorhergehenden Ansprüche, wobei die Deckschicht (6) auf die erste und/oder zweite Außenfläche (2, 3) lediglich in zumindest einem Teilbereich des Glassubstrats (1) aufgebracht wird.

8. Verfahren nach zumindest einem der vorhergehenden Ansprüche, wobei die Modifikationen in das Volumen zwischen beiden Außenflächen (2, 3) mittels mehrerer, die beiden Außenflächen (2, 3) verbindenden Laserstrahlen von einer Seite eingebracht werden.

9. Verfahren nach zumindest einem der vorhergehenden Ansprüche, wobei die Modifikationen durch die Laserstrahlung mit einer Strahlachse senkrecht zu der jeweiligen Oberfläche des Glassubstrats (1) eingebracht werden.

10. Verfahren nach zumindest einem der vorhergehenden Ansprüche, wobei zumindest eine Deckschicht (6) mit einer zusätzlichen funktionellen Schicht verstärkt wird.

11. Verfahren nach zumindest einem der vorhergehenden Ansprüche, wobei der Fokus der Laserstrahlung relativ zu dem Glassubstrat (1) unverändert ist, während die Modifikationen eingebracht werden.

12. Verfahren nach zumindest einem der vorhergehenden Ansprüche, wobei die Modifikationen durch eine Gruppe von Einzelpulsen erzeugt werden, wobei der Fokus der Laserstrahlung während der Dauer der Gruppe von Einzelpulsen relativ zu dem Glassubstrat (1) unverändert ist.

13. Verfahren nach zumindest einem der vorhergehenden Ansprüche, wobei die Einzelpulse derselben Gruppe von Einzelpulsen mit einem zeitlichen Abstand kleiner als 1 µs in das Glassubstrat (1) eingebracht werden.

14. Verfahren nach zumindest einem der vorhergehenden wobei der zeitliche Abstand zwischen zwei aufeinanderfolgenden Gruppen von Einzelpulsen größer ist als der zeitliche Abstand zwischen den Einzelpulsen innerhalb einer Gruppe von Einzelpulsen.

## Claims

1. Method for producing microstructures in a glass substrate (1), wherein modifications are initially introduced by means of laser radiation into at least one volume between mutually opposite outer faces (2, 3), wherein a chemical conversion of the substrate material takes place because of the laser action during the modification, and a multiplicity of recesses (5), which in particular are conical at least in sections, are subsequently generated by an etching method by means of anisotropic material erosion in the at least one outer face (2, 3) of the glass substrate (1), wherein after the etching, a layer which is resistant to the etching action of the etching method is applied as a cover layer (6) in a region which encloses at least individual recesses (5), onto only one of the two outer faces (2) as a first outer face, and a further method of etching the glass substrate (1) is then carried out so that material erosion takes place in the second outer face (3) remote from the cover layer (6), until the recesses (5) of the second outer face (3), which have been generated and/or enlarged in this way, have reached the cover layer (6).

2. Method according to Claim 1, wherein the second outer face (3) is eroded by the etching in such a way that the cover layer (6) of the first outer face (2) protrudes from the remaining plane of the second outer face (3).

3. Method according to Claim 1 or 2, wherein the cover layer (6) is applied from a material composition having a good electrical conductivity.

4. Method according to at least one of the preceding claims, wherein a cover layer (6) is applied onto the second outer face (3).

5. Method according to at least one of the preceding claims, wherein the cover layer (6) is applied onto the second outer face (3) after the recesses (2) in the second outer face (3) have reached the cover layer (6) of the first outer face (2) because of the progressive material erosion.

6. Method according to at least one of the preceding claims, wherein the cone angle (α) of the recesses (5) is adjusted by the cover layer (6) of the first outer face (2) and/or the laser parameters.

7. Method according to at least one of the preceding claims, wherein the cover layer (6) is applied onto the first and/or second outer face (2, 3) only in at least one subregion of the glass substrate (1).

8. Method according to at least one of the preceding claims, wherein the modifications are introduced into the volume between the two outer faces (2, 3) from one side by means of a plurality of laser beams which join the two outer faces (2, 3).

9. Method according to at least one of the preceding claims, wherein the modifications are introduced by the laser radiation with a beam axis perpendicular to the respective surface of the glass substrate (1).

10. Method according to at least one of the preceding claims, wherein at least one cover layer (6) is reinforced with an additional functional layer.

11. Method according to at least one of the preceding claims, wherein the focus of the laser radiation is unchanged relative to the glass substrate (1) while the modifications are being introduced.

12. Method according to at least one of the preceding claims, wherein the modifications are generated by a group of individual pulses, the focus of the laser radiation being unchanged relative to the glass substrate (1) throughout the duration of the group of individual pulses.

13. Method according to at least one of the preceding claims, wherein the individual pulses of the same group of individual pulses are introduced into the glass substrate (1) with a temporal spacing of less than 1 ps.

14. Method according to at least one of the preceding claims, wherein the temporal spacing between two successive groups of individual pulses is greater than the temporal spacing between the individual pulses within a group of individual pulses.

## Revendications

1. Procédé de réalisation de microstructures dans un substrat de verre (1), des modifications étant d'abord introduites dans au moins un volume situé entre des surfaces extérieures (2, 3), opposées entre elles, à l'aide d'un rayonnement laser, ledit procédé effectuant une transformation chimique du matériau de substrat lors de la modification en raison de l'action du laser, puis un grand nombre d'évidements (5), en particulier coniques au moins par portions, étant généré dans l'au moins une surface extérieure (2, 3) du substrat de verre (1) au moyen d'un procédé de gravure par enlèvement de matière anisotrope, une couche résistante à l'effet de gravure du procédé de gravure étant appliquée après la gravure comme couche de recouvrement (6) dans une zone incluant au moins des évidements individuels (5) sur seulement une des deux surfaces extérieures (2) comme première surface extérieure, puis un autre procédé de gravure du substrat de verre (1) étant mis en œuvre de façon à enlever de la matière dans la deuxième surface extérieure (3) opposée à la couche de recouvrement (6) jusqu'à ce que les évidements (5) ainsi générés et/ou élargis de la deuxième surface extérieure (3) aient atteint la couche de recouvrement (6).

2. Procédé selon la revendication 1, la deuxième surface extérieure (3) étant enlevée par la gravure de manière à ce que la couche de recouvrement (6) de la première surface extérieure (2) émerge du plan restant de la deuxième surface extérieure (3).

3. Procédé selon la revendication 1 ou 2, la couche de recouvrement (6) étant appliquée à partir d'une composition de matériau ayant une bonne conductivité électrique.

4. Procédé selon l'une au moins des revendications précédentes, une couche de recouvrement (6) étant appliquée sur la deuxième surface extérieure (3).

5. Procédé selon l'une au moins des revendications précédentes, la couche de recouvrement (6) étant appliquée sur la deuxième surface extérieure (3) après que les évidements (2) dans la deuxième surface extérieure (3) ont atteint la couche de recouvrement (6) de la première surface extérieure (2) en raison de l'enlèvement de matériau progressif.

6. Procédé selon l'une au moins des revendications précédentes, l'angle de cône (α) des évidements (5) étant réglé par la couche de recouvrement (6) de la première surface extérieure (2) et/ou les paramètres du laser.

7. Procédé selon l'une au moins des revendications précédentes, la couche de recouvrement (6) étant appliquée sur la première et/ou la deuxième surface extérieure (2, 3) uniquement dans au moins une sous-zone du substrat de verre (1).

8. Procédé selon l'une au moins des revendications précédentes,
les modifications étant introduites d'un côté dans le volume situé entre les deux surfaces extérieures (2, 3) au moyen de plusieurs faisceaux laser reliant les deux surfaces extérieures (2, 3).

9. Procédé selon l'une au moins des revendications précédentes, les modifications étant introduites par le rayonnement laser avec un axe de faisceau perpendiculaire à la surface respective du substrat de verre (1).

10. Procédé selon l'une au moins des revendications précédentes, au moins une couche de recouvrement (6) étant renforcée par une couche fonctionnelle supplémentaire.

11. Procédé selon l'une au moins des revendications précédentes, la focalisation du rayonnement laser restant inchangée par rapport au substrat de verre (1) pendant que les modifications sont introduites.

12. Procédé selon l'une au moins des revendications précédentes, les modifications étant générées par un groupe d'impulsions individuelles, la focalisation du rayonnement laser restant inchangée par rapport au substrat de verre (1) pendant la durée du groupe d'impulsions individuelles.

13. Procédé selon l'une au moins des revendications précédentes, les impulsions individuelles du même groupe d'impulsions individuelles étant introduites dans le substrat de verre (1) avec un intervalle de temps inférieur à 1 ps.

14. Procédé selon l'une au moins des revendications précédentes, l'intervalle de temps entre deux groupes successifs d'impulsions individuelles étant supérieur à l'intervalle de temps entre les impulsions individuelles à l'intérieur d'un groupe d'impulsions individuelles.
